# EUROPEAN PATENT APPLICATION

(11) **EP 1 383 182 A2**
(43) Date of publication of application: **21.01.2004**
(21) Application number: 03425450.8
(22) Date of filing: 08.07.2003
(51) Int. Cl.: H01L 51/20, H01L 23/00

(54) **System for applying a gas sorbing device on a surface and processes for the production thereof**

(30) Priority: 17.07.2002 IT MI20021579
(71) Applicant: SAES GETTERS S.p.A., Lainate (Milano) (IT)
(72) Inventor: Della Porta, Anna, 20121 Milano MI (IT)
(74) Representative: Adorno, Silvano

(57) **Abstract**

The present invention relates to a system (10, 20, 30, 40, 50, 60) for applying a gas sorbing device (14, 24, 34, 44, 54, 64) on an inner surface of electronic devices or the like, in which upper (11, 21, 31, 41, 51, 61) and lower (12, 22, 32, 42, 52, 62) protective sheets, both being removable and substantially gastight, define one or more spaces within which at least a sorbing device (14, 24, 34, 44, 54, 64) is arranged. Said sorbing device comprises at least a layer of getter material (15, 25, 35, 45, 55, 65) deposited on supporting and securing means (16, 26, 36, 46, 56, 66), that in turn comprise at least a first layer of adhesive material (162, 262, 362; 46, 56, 66) suitable to effect the fixing of said sorbing device (14, 24, 34, 44, 54, 64) on said application surface. The invention further relates to some processes for the production of such a system.

## Description

The present invention relates to a system for applying a gas-sorbing device on a surface, in particular within a gas sensitive electronic device, as well as to some processes for producing such a system.

It is known that the functionality of some electronic devices can be altered by the contact with some gases and particularly water, even when present in traces. It is for example the case of semiconductor devices, wherein water can oxidize the electric contacts or chemically alter some parts of the device, or the laser amplifiers used in the communications through optic fibers. A further electronic application having a high industrial interest and in which there is required the absence of water are the electroluminescent screens based on the use of organic materials and known in the specific sector under the expression "Organic Light Emitting Devices" or its acronym OLED that will be used herein below.

In the rest of the description, reference will be made to OLEDs as example of application of the systems and sorbing devices of the invention, but it is understood that these have a broader applicability, in each case when it is necessary to maintain vacuum or a controlled atmosphere and there's only a limited space available for the gas sorbing device; besides, in the rest of the description and in the claims, gas sorbing materials and devices will also be referred to as "getter materials" and "getter devices" respectively.

In short, the structure of an OLED is formed by a first essentially planar transparent support, generally made of glass or of a plastic polymer; a first series of linear and mutually parallel, transparent electrodes (generally with anodic functionality) which are deposited on first support; a double layer of different electroluminescent organic materials, the first of which being a conductor of electronic vacancies (also named "holes") and the second one of electrons, that are deposited on the first series of electrodes; a second series of linear and reciprocally parallel electrodes (generally with cathodic functionality) that are orthogonally oriented with respect to those of the first series and in contact with the top part of the double layer of organic materials in such a manner that the latter is comprised between the two series of electrodes; and a second essentially planar, not necessarily transparent support that can be made of glass or plastic material and which is parallel to the first support. The two supports are fixed together along their perimeter, generally by gluing, so that the active portion of the structure (electrodes and electroluminescent organic materials) is housed in a closed space. The first transparent support is the portion where the image is displayed, whereas the second support has generally the only function to close and support the device, so as to give it a sufficient mechanical resistance.

The anode is formed of a transparent conducting material, in general the mixed oxide of indium and tin (In₂O₃-SnO₂) which has features of a semiconductor and is known in the field with the initials ITO (Indium Tin Oxide), whereas the cathode is formed of alkaline-earth metals such as Ba, Ca, or Mg-Ag and Al-Li alloys. When a potential difference is applied to the electrodes, the electron and holes are conveyed to the double layer of organic material and there combine giving rise to photons whose wavelength depends on the nature of the employed organic material.

For an explanation of the operating principles of OLEDs and for further details on their structure reference is made to the ample literature in the field.

The main problem encountered with these devices is that they lose rapidly their features of light emission upon sorption of some gases, such as water vapor that penetrates mainly by permeation through the epoxy resin layers generally employed for carrying out the peripheral joining of the supports, or by release from the same resins. Other gases that are likely to be capable of damaging the OLED are the oxidizing ones, such as oxygen and carbon dioxide. The life of these devices decreases from thousands or tens of thousands of hours in the absence of moisture, as experimentally verified in controlled environment chambers, down to few hours when exposed in air. Even though the functional worsening processes of the OLEDs are not yet been fully explained, it is likely the phenomenon may be ascribed on one hand to addition reactions of water molecules with the unsaturated bonds of the organic component, and on the other to the reaction of water with the electrodes, in particular metal electrodes. The areas affected by these reactions lose their light emitting functionality, thus appearing as black spots on the screen surface.

With a view to overcome the problem, the patents US-A-5,804,917 and US-A-5,882,761 and the published international applications WO 98/59356 and WO 99/35681 describe the use of getter materials inside electronic devices. All of these documents teach however using the getter material in a generic manner, and do not explain how it is possible to incorporate into the device producing process the introduction step of getter material in the OLED.

The international patent application PCT/IT01/00489 in the applicant's name describes a moisture sorbing system that is specific for OLEDs. This system comprises a water permeable membrane capable of keeping solid particles, whose perimetral edge is secured to an impermeable sheet. In the closed space between said membrane and said sheet there is formed a cavity suited to enclose a powdery getter material.

In order to prevent the getter material from becoming deactivated at the contact with air moisture or other noxious gases even before it brings its sorbing action within the electronic device, it is necessary to maintain the moisture sorber in an inert atmosphere or under vacuum till the moment of use. For this reason, immediately after preparation said sorber is placed inside closed envelopes made for instance of multilayers comprising thin metal foils, and kept in such envelopes up to the moment of application thereof to the electronic device, application that is generally carried out inside a glove box.

However, even in this way it is not possible to prevent the sorbers from becoming at least partially deactivated. These sorber devices are generally packed in envelopes containing a purality of devices: once the package is opened, the devices are all simultaneously exposed to the atmosphere in the glove box, but are inserted into the final application device at different times, so that the exposure time to the chamber atmosphere is different for each device in the original package. As it is impossible to totally prevent unwanted gases from entering into said boxes, this leads to the result that each device will be partially spent to a different degree, depending on said exposure time, thus leading to non reproducibility of the behaviour of the gettering function in different final electronic devices. The sole way to avoid this problem would be to provide a single envelope for each sorbing device, so that each one could be applied to the electronic device soon after the envelope has been opened. This would however involve not only a remarkable increase of production cost of the sorbers, but also a prolongation of the production process of the electronic devices, due to the long times required for opening the envelopes and withdrawing a sorber from each of them.

A further disadvantage of the system described in the above named patent application resides in that, in order to assure the mechanical stability of the system, it cannot be produced with too reduced thickness and this is in contrast with the steady trend of this sector. As a matter of fact, in view of the miniaturization demands of electronic devices, it is generally required that the sorbing system has reduced size, and in particular a reduced thickness, to take up as little room as possible in the housing of the electronic device.

In addition, the positioning systems usable with the known sorbers risk damaging the configuration of the sorber when this is very thin, by altering thus its thickness.

The Japanese publications JP2000-A-195660 and JP2000-A-277254 disclose methods of applying a sorbing material directly on the back wall of a gas-sensitive electronic device. The first publication describes in particular the deposition of calcium, strontium or barium hydrides directly carried out on the back wall of an electronic device, whereas in the second case the sorbing materials are kneaded with silicone and coated on said wall.

The deposition of the sorbing material on the panel wall is however an additional working step during the electronic device production process, and involves therefore a protraction of the time required for such a process.

The patent US 5,091,233 describes an evacuated thermo-insulating panel, which is usable in walls of household- or industrial refrigerators and contains inside a getter structure. Such a structure comprises a substrate on which a layer of getter material is deposited that is in turn lagged by a barrier sheet. The getter material becomes thus sandwiched between said substrate and said barrier sheet, at least one of which must necessarily be made of a gas-semi permeable material, so as to allow the gas permeation towards the getter material. The semi permeable material may be a polymeric film, for example PET (polyethylene-terephthalate) possibly coated on a side by a layer of a thermo-adhesive material having the role of increasing the stability of the structure, and being activated at the production moment of the getter structure through a passage on hot rollers.

The gas permeability of said substrate or sheet must be suitably selected so that the gas passage occurs at a sufficiently low speed to prevent an inactivation of getter material during the construction steps of the insulating panel, yet high enough to allow a sufficient sorption.

However an inconvenience of the getter structure described in said US patent resides just in that its gas sorption rate is necessarily limited, since the getter material is not in direct contact with the inner environment of the insulating panel. This restriction makes such structures totally unsuitable for uses different from the one described in the patent. In particular, the described getter structures do not lend themselves to the application in an electronic device, wherein even a very low concentration of gases for a short period can cause remarkable damages to the device.

The object of the present invention is therefore to provide a system for applying a gas sorbing device on an inner surface of an electronic device or the like, that is free from said drawbacks, as well as a process for the production thereof. Said object is achieved through a system whose main features are specified in the first claim and other features are specified in the subsequent claims, while the features of processes for the production thereof are specified in claims 21 and 22.

A first advantage of the system according to the present invention resides in that, thanks to the presence of two removable and gas impermeable protective layers adhesively bonded together, it enables to apply a sorbing device comprising a getter material on the inside of an electronic device in an extremely simple and speedy way, thus avoiding to lengthen the times of the process for producing the electronic device, but so as to maintain said getter material shielded from the outer environment up to the application moment.

Another advantage of the system according to the present invention resides in that it allows to apply a sorbing device having an extremely reduced thickness, for example thicknesses of few microns. Furthermore, the sorbers according to the present invention can be placed inside an electronic device in an extremely simple manner. The positioning system that can be used allows in addition to maintain unchanged the structural features of the sorbers, even when these are very thin.

An advantage of the system according to a particular embodiment of the invention resides in that it enables the final user to choose the size and shape of the device to be applied only at the moment of use, and to carry out said application in an extremely simple way by applying a simple pressure on the system according to the present invention.

Further advantages and features of the system according to the present invention will become evident to the skilled persons from the following detailed specification of some embodiments thereof with reference to the attached drawings wherein:
- Figure 1 shows a sectional partial view of a system according to a first embodiment of the invention;
- Figure 1a shows the sorbing device of the system of figure 1;
- Figure 2 shows a sectional partial view of a system according to a second embodiment of the invention;
- Figure 3 shows a sectional partial view of a system according to a third embodiment of the invention;
- Figure 3a shows the sorbing device of the system of figure 3;
- Figure 4 shows a sectional partial view of a system according to a fourth embodiment of the invention;
- Figure 4a shows the sorbing device of the system of figure 4;
- Figure 5 shows a sectional partial view of a system according to a fifth embodiment of the invention;
- Figure 6 shows a sectional partial view of a system according to a sixth embodiment of the invention.

For sake of representation clarity, the elements shown in the drawings are not to scale, and particularly the thicknesses are highly increased with respect to the lateral dimensions. Besides, the application examples are referred to the use in the inside of OLEDs, but the inventive system may be employed for the application of a gas-sorbing device on an inner surface of any electronic device that must be kept under vacuum or controlled atmosphere, in particular when the available thicknesses are scanty.

As it appears from the figures, the system according to the present invention comprises at least two external protective sheets of the sorbing device, being substantially gas impermeable, which are mutually connected in a removable way and define one or more spaces that are sufficiently gastight. Within each one of said spaces at least a sorbing device is placed, comprising at least a layer of getter material deposited on supporting and securing means. Said supporting and securing means comprise in turn at least a first layer of adhesive suited to effect the fixing of said sorbing device on said application surface.

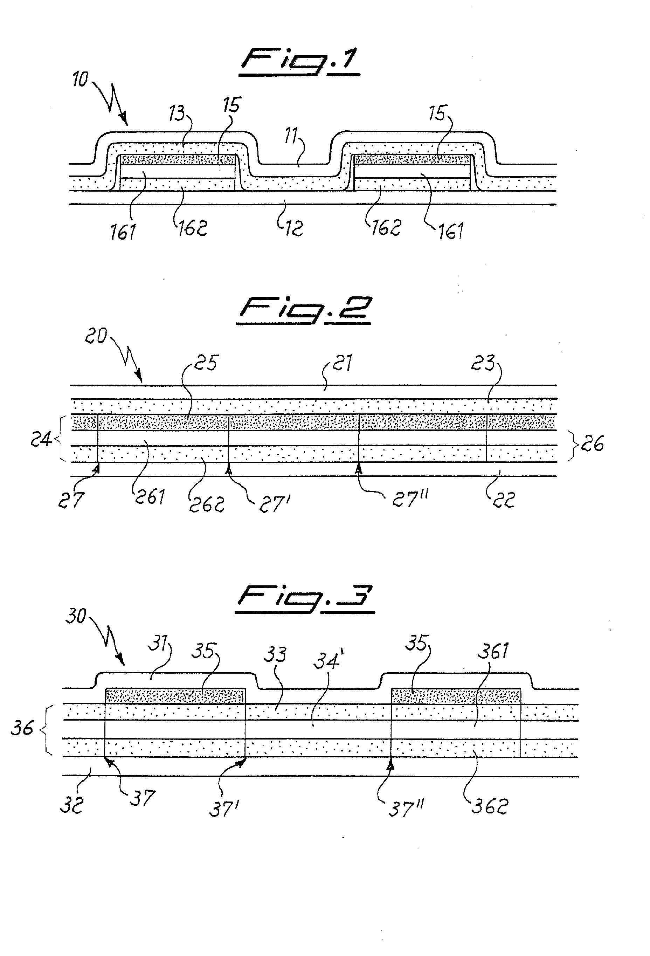

With reference to figure 1, it can be seen that a system 10 according a first embodiment of the invention comprises an upper protective sheet 11 and a lower protective sheet 12, both made of a gas impermeable material and joined together by a second adhesive layer 13 of removable type which is placed on a whole face of said upper protective sheet 11. The terms "upper" and "lower" as used in the present specification and claims refer to the orientation of the inventive system as it is represented in the figures, but it is clear that said system could be otherwise oriented according to the position of the application surface.

Between said protective sheets 11 and 12 many spaces are thus defined, each of which is suited to receive a sorbing device 14 represented in detail in figure 1a. Said device comprises a layer of getter material 15 deposited on appropriate supporting and securing means 16.

The supporting and securing means 16 of sorbing device 14 according to the present embodiment of the invention are obtained from a monoadhesive sheet including a support 161, having on its upper surface the deposit of getter material 15, and on the lower one a first layer of adhesive 162 of the system, which is lined at the bottom by said protective sheet 12. Said monoadhesive sheet is suitably die cut along the periphery of the deposit of getter material 15, and the exceeding or scrap portions are removed.

Said adhesive layer 162 is preferably of permanent type, for example an acrylic adhesive, that allows a final fixing of the sorbing device 14 to the application surface. Sheet 12, or at least its upper surface, will be made of or coated with an anti-adherence material, such as siliconated paper, to allow easy detachment of layer 162 from this sheet.

Taking always reference to figure 1, there can be seen that said spaces, which are defined at the top and at the bottom by said protective sheets 11 and 12, are laterally closed by said second layer of removable adhesive 13. One could believe that within said space the sorbing devices 14 are not enough protected against a lateral inflow of gases, in that a layer of adhesive does not usually form a real screen to gas. On the contrary, it has been found that the inflow of gases towards the sorbing devices mainly occurs from the upper and lower sides that are effectively shielded by said protective sheets. For this reason, the sorbing devices which are received in spaces within said systems according to the various embodiments of the present invention are enough shielded against the gas inflow, so that even after withdrawal from an outer protecting envelope, the sorbing devices can withstand the external environment under normal conditions up to the application time.

Preferably said protective sheets 11 and 12 are widely sized, and between them a plurality of sorbing systems 14 are placed. For instance, said upper and lower protective sheets may be in the form of bands, so that the inventive system can be supplied to the final user as a reel. Between the protective sheets, there can be placed a row of sorbing devices 14, to be detached at the time of application on an inner surface of an electronic device in the following manner. By working in an inert atmosphere, a portion of lower protecting sheet 12 is detached being sufficient to free the adhesive layer 162 of at least a sorbing device 14. This layer 162 is caused to adhere to said application surface, and subsequently the upper protective sheet 11 is removed, while sorbing device 14 will remain stuck to the application surface.

Taking reference to figure 2, there is shown that a system 20 according to another embodiment of the invention comprises a lower protective sheet 22 and an upper protective sheet 21, which one is coated at the bottom by a layer of removable adhesive 23. Between said protective sheets 21 and 22 there is placed a sorbing device according the invention, marked with reference number 24, that is formed by a continuous multilayer comprising a layer of getter material 25 deposited on supporting and fixing means 26, formed in this case too by a monoadhesive sheet.

Also in this case, system 20 is preferably widely sized, so that from it many sorbing devices 24 can be detached. In order to avoid that the final user must carry out cutting operations at the time of application, it is advisable that the continuous multilayer be provided with internal vertical cuttings, shown by numerals 27, 27', 27", ..., which subdivide it in individually detachable units. Each unit is thus enclosed in a space defined by upper 21 and lower 22 protecting sheets and by the adjacent units, and is effectively shielded from contact with the atmosphere up to the application time.

Such application can be effected by following a procedure similar to that already explained for the system according to the first inventive embodiment.

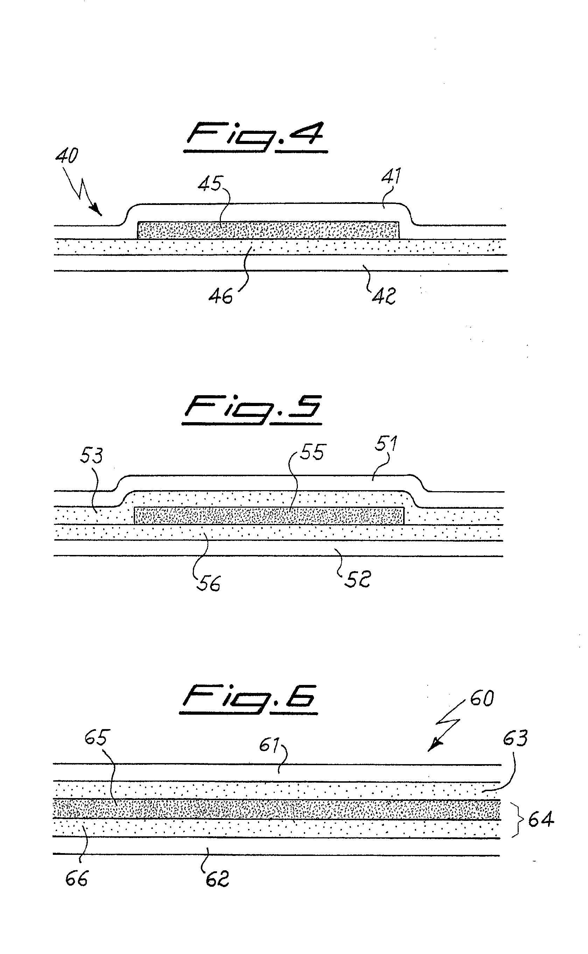

As it appears from figures 3 and 3a, in a third embodiment of the system according to the present invention, an upper protecting sheet 31 is placed directly in contact with a layer of getter material 35 which is deposited, as previously explained for the other embodiments of the invention, on suitable supporting and fixing means 36. Said means are formed in this case by a biadhesive sheet which comprises a support 361 bearing on both faces said first and second adhesive layers of the system, here shown respectively by numbers 33 and 362. The first adhesive layer 362 is lined on its lower face by lower protecting sheet 32.

Upper protecting sheet 31 that in the represented case is a simple sheet of polymeric material could also be formed by a monoadhesive sheet.

Preferably, similarly to what has been described with reference to figure 1, the upper and lower protective sheets are widely sized and enclose in their inside a plurality of sorbing systems 34 that can be detached by the final user at the time of use. The supporting and fixing means 36 of various sorbing devices can be obtained from a single biadhesive sheet, possibly in the form of a band, which is suitably die cut at the various deposits of getter material 35, viz. along lines 37, 37', 37"..., . Each sorbing device 34 will thus result placed in a closed space that is delimited by said upper 31 and lower 32 protective sheets and by the adjacent portions of biadhesive sheet forming the scrap portions 34'.

At the time of application, by removing the protective sheet 32 it will be possible to cause one or more sorbing devices 34 to adhere to an application surface by separating them from the scrap portions.

The inventive systems so far described can be produced according to a process comprising the following operations:
- providing a mono- or bi-adhesive sheet;
- forming on said sheet at least a deposit of a getter material;
- die cutting said mono- or bi-adhesive sheet so as to leave intact the lower protecting sheet; and
- lining said deposit of getter material by an upper protecting sheet.

The deposition of getter material can be carried out by known methods, for example by means of evaporation or sputtering techniques. In the case it is desired to carry out a plurality of discrete deposits on the surface of a mono- or bi-adhesive sheet, it is necessary to previously arrange a masking of the sheet.

Obviously, the upper protecting sheet is necessarily a removable monoadhesive sheet when it is desired to produce the systems of figures 1 and 2, whereas it can be a simple sheet of polymeric material for the system of figure 3.

There will be now described three further embodiments of the inventive system which are particularly advantageous in that, as it will be clear, the process for the production thereof is particularly easy and speedy, and does not involve die cutting steps. In such further embodiments, the supporting and fixing means of the sorbing device are only formed by said first adhesive layer of the system, being not present any other additional supporting layer.

Taking now reference in particular to figure 4, there is represented a system 40 according to a fourth embodiment of the invention in which, once again, a sorbing device 44 is placed between upper 41 and lower 42 protecting sheets.

As it more clearly appears in figure 4a, the sorbing device 44 is merely formed by a layer of getter material 45 and an adhesive layer. It is this last layer that forms the supporting and fixing means 46 of the device and plays also the role of directly connecting said upper protecting sheet 41 and said lower protecting sheet 42 in the area surrounding said sorbing device 44.

At the time of application, after having detached the lower protecting sheet 42 and stuck the adhesive layer 46 to the application surface, the upper protecting sheet 41 is removed, to which remain stuck the portions of adhesive layer that do not lie below the deposit of getter material 45. The device 44 becomes thus applied to the inner surface of any electronic device.

A system for applying a sorbing device like that represented in figure 4a is system 50 of figure 5. In addition to the elements of system 40, said system 50 comprises also a second removable adhesive layer 53, which in the area surrounding the getter material is directly in contact with the first adhesive layer 56. For this reason, at the time of applying the sorbing device, the detachment of upper protecting layer 51 causes also in this case the separation of the parts of adhesive layer 56, not underlying the deposit of getter material, that remain attached to said protecting sheet 51. With respect to the previous inventive embodiment, the one just described has the advantage of a greater stability of the sorber, thanks to a better adhesion of the getter film to the upper protecting sheet during the application.

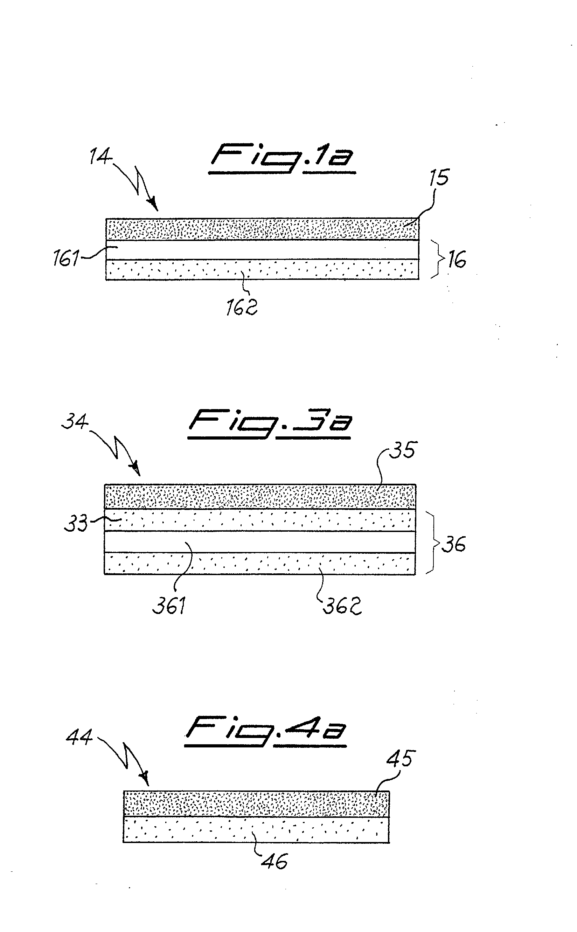

The inventive system represented in figure 6 comprises the same elements as the one just described, except that a deposit of getter material 65 coats totally a first adhesive layer 66. In other words, the sorbing device 64 comprising said layers 65 and 66 forms a continuous multilayer placed between a second adhesive layer 63 and a lower protective sheet 62.

The just illustrated embodiment of the invention is especially advantageous in that it enables the final user to transfer on the application surface a desired portion of sorbing device by selecting the size and shape thereof at the time of use only, and to effect said application in an extremely simple manner by acting in the following way.

Initially the protective sheet 62 is detached so as to partially or totally free said first adhesive layer 66 that is made to adhere to an application surface. Then, a compression is applied on a desired area of protective sheet 61 in order to transfer on said application surface a sorbing device unit having a shape and size corresponding to that of the area on which the compression was applied. In this manner, on the application surface a sorbing device is applied having a shape and size as stated at the moment of use.

Optionally, said lower protective sheet 62 can be die cut, so that at the time of application of sorbers it will be possible to detach therefrom some parts only, thus producing holes in said lower sheet. In this case, the compression is applied on areas of upper protective sheet 61 which correspond to said holes, whereas the portion of lower protective sheet that remains attached to the system helps in preventing the adhesive layer 66 from sticking to unwanted areas of the application surface.

The systems according to the last described embodiments of the invention can be produced following to a process comprising the following operations:
- providing a lower protective sheet;
- coating said lower protective sheet with a first adhesive layer;
- forming one or more deposits of getter material on said first adhesive layer; and
- lining said deposit(s) of getter material with an upper protective sheet.

Also in this case, the deposits of getter material may be obtained by sputtering or evaporation, optionally with masking, and the upper protective layer is a removable monoadhesive sheet when it is desired to produce the systems of figures 5 and 6.

For the system of figure 4, the upper protective sheet 41 is a simple sheet of substantially gastight polymeric material or a sheet of plastic material of the kind commonly used for transferable inks. In this latter case, the above-described process can be changed by carrying out the deposition of getter material 45 directly on upper protective sheet 41 rather than on the layer of adhesive material 46.

The sorbing devices applicable through the system according to the invention may reach extremely reduced thicknesses. Indeed, their thickness is obviously given by the sum of the thickness of said supporting and fixing means and of that of getter material. The first means are formed, as it was said, by a mono- or bi-adhesive sheet having generally a thickness comprised between about 4 and 50 µm, or by a simple adhesive layer, whereas the thickness of getter layer varies according to the used getter material and application type.

To realize the system according to the present invention it is in fact possible to use any known getter material that is regarded as suitable for the sorption of gases; in particular there are preferred the earth-alkali metals, their oxides and alloys. For the use within OLEDs of the sorbing devices according to the invention, it is preferable to employ as getter materials, barium, strontium or calcium metals or their oxides.

The upper and lower protective sheets may consist of any material having a good gas tightness. For example, polymeric materials of barrier type, such as PET, PTFE, PVC, HDPE, LDPE and LLDPE are usable. For the lower protective sheet, siliconated paper or siliconated PET sheets are employable, which materials facilitate the release of the sheet from the over standing adhesive material.

As already said, the first adhesive layer, namely the layer directly contacting the lower protective sheet, preferably consists of a permanent adhesive, for instance an acrylic material, that allows to permanently secure the sorbing device to the application surface.

The second adhesive layer, namely the layer allowing to secure the upper protective sheet to the sorbing device, consists instead necessarily of a removable adhesive.

## Claims

1. A system (10, 20, 30, 40, 50, 60) for the application of a gas sorbing device (14, 24, 34, 44, 54, 64) on an inner surface of electronic devices or the like, wherein upper (11, 21, 31, 41, 51, 61) and lower (12, 22, 32, 42, 52, 62) protective sheets, being both removable and substantially gastight, define one ore more spaces within which at least a sorbing device (14, 24, 34, 44, 54, 64) is placed that comprises at least a layer of getter material (15, 25, 35, 45, 55, 65) deposited on supporting and securing means (16, 26, 36, 46, 56, 66), said supporting and securing means comprising at least a first layer of adhesive material (162, 262, 362, 46, 56, 66) suited to effect the fixing of said sorbing device (14, 24, 34, 44, 54, 64) on said application surface.

2. The system according to claim 1, also comprising a second adhesive layer (13, 23, 33, 53, 63) that allows to removably connect said upper and lower protecting sheets.

3. The system according to claim 2, wherein said supporting and securing means (16, 26, 36) comprise at least a supporting sheet (161, 261, 361) on a face of which said first adhesive layer (162, 262, 362) is disposed.

4. The system according to claim 3, wherein said layer of getter material (15, 25) is directly deposited on said supporting sheet (161, 261), and wherein said second adhesive layer (13, 23) is arranged on at least a face of said upper protective sheet (11, 21).

5. The system according to claim 4, wherein said sorbing device (14) has a lesser extent with respect to said protective sheets (11, 12) which in the area surrounding said sorbing device are directly connected through said second adhesive layer (13).

6. The system according to claim 4, wherein said sorbing device (24) forms a continuous multilayer disposed between said second adhesive layer (23) and said lower protective sheet (22), and wherein said sorbing device (24) has inner die cuts subdividing it in individually detachable units.

7. The system according to claim 3, wherein on the face of said supporting sheet (361) opposed to said first adhesive layer (362) there is placed said second adhesive layer (33), on said second adhesive layer (33) there being disposed said layer of getter material (35) in the form of one or more discrete deposits having a lesser extent than that of said second adhesive layer (33).

8. The system according to claim 4 or 7, wherein said supporting and securing means consist of a continuous sheet provided with inner die cuts.

9. The system according to claim 1, wherein said getter material (45, 55, 65) is deposited directly on said first adhesive layer (46, 56, 66).

10. The system according to claim 9, wherein said sorbing device (44, 54) has a lesser extent with respect to said protective sheets (41, 42; 51, 52).

11. The system according to claim 10, wherein said first adhesive layer (43) has also the role of connecting directly said upper protective sheet (41) and said lower protective sheet (42) in the area surrounding said sorbing device (44).

12. The system according to claim 10, wherein a second adhesive layer (53) enables a removable connection of said upper (51) and lower (52) protective sheets and is directly in contact with said first adhesive layer (56) in the area surrounding said sorbing device.

13. The system according to claim 9, wherein said sorbing device (64) forms a continuous multilayer disposed between said second adhesive layer (63) and said lower protective sheet (62).

14. The system according to any previous claim, wherein said upper (11, 21, 31, 41, 51) and lower (12, 22, 32, 42, 52, 62) protective sheets are in the form of continuous bands.

15. The system according to any preceding claim, wherein said getter material (15, 25, 35, 45, 55, 65) is selected among earth-alkali metals, their oxides and alloys.

16. The system according to claim 15, wherein said getter material (15, 25, 35, 45, 55, 65) is selected from the group comprising barium, strontium, calcium and their oxides.

17. The system according to any preceding claim, wherein the adhesion between said upper protective sheet (11,21,31,41, 51, 61) and the sorbing device (14, 24, 34, 44, 54, 65) is stronger than the adhesion between the lower protective sheet (12, 22, 32, 42, 52, 62) and the sorbing device (14, 24, 34, 44, 54, 64) so as to facilitate the removal of lower protective sheet (12, 22, 32, 42, 52, 62) from sorbing device (14, 24, 34, 44, 54, 64) while the latter remains fixed to the upper protective sheet (11, 21, 31, 41, 51, 61).

18. The system according to any preceding claim, wherein the adhesive of said first layer (162, 262, 362, 46, 56, 66) is of permanent type.

19. The system according to claim 18, wherein the adhesive of said first layer is an acrylic adhesive.

20. The system according to any preceding claim, wherein said lower (11, 21, 31, 41, 51, 61) and upper (12, 22, 32, 42, 52, 62) protective sheets are made of polymeric material.

21. A process for the production of a system according to any claim from 1 to 8, wherein there are effected the following operations:
- providing a mono- or bi-adhesive sheet;
- forming on said sheet at least a deposit of a getter material;
- die cutting said mono- or bi-adhesive sheet so as to leave intact the lower protective sheet; and
- lining said deposit of getter material with an upper protective sheet.

22. A process for the production of a system according to any claim from 9 to 20, wherein there are effected the following operations:
- providing a lower protective sheet;
- coating said lower protective sheet with a first adhesive layer;
- forming one or more deposits of getter material on said first adhesive layer; and
- lining said deposit(s) of getter material with an upper protective sheet.

23. The process according to claim 21 or 22, **characterized in that** it further comprises a masking step prior to the depositions of getter material.
